Europäisches Patentamt

European Patent Office

Office européen des brevets

(19)

(11) **EP 1 462 822 A1**

(12) **EUROPEAN PATENT APPLICATION**
published in accordance with Art. 158(3) EPC

(43) Date of publication:
**29.09.2004 Bulletin 2004/40**

(51) Int Cl.⁷: **G01S 13/93**, G01S 7/28

(21) Application number: **01274658.2**

(22) Date of filing: **09.11.2001**

(86) International application number:
**PCT/JP2001/009821**

(87) International publication number:
**WO 2003/040754 (15.05.2003 Gazette 2003/20)**

(84) Designated Contracting States:
**AT BE CH CY DE DK ES FI FR GB GR IE IT LI LU MC NL PT SE TR**

(71) Applicant: **Hitachi, Ltd.**
**Chiyoda-ku, Tokyo 101-8010 (JP)**

(72) Inventors:
• **NAKAZAWA, Terumi, HITACHI, LTD.**
**Hitachinaka-shi, Ibaraki 312-0062 (JP)**
• **TABUCHI, Kenji, HITACHI, LTD.**
**Hitachinaka-shi, Ibaraki 312-0062 (JP)**

• **EGUCHI, Shuji, HITACHI, LTD.**
**Hitachinaka-shi, Ibaraki 312-0062 (JP)**
• **FUJITA, Tsuyoshi, c/o HITACHI, LTD.**
**Yokohama-shi, Kanagawa 244-0817 (JP)**
• **SHIGI, Hidetaka, HITACHI, LTD.**
**Yokohama-shi, Kanagawa 244-0817 (JP)**

(74) Representative: **Beetz & Partner Patentanwälte**
**Steinsdorfstrasse 10**
**80538 München (DE)**

(54) **MOBILE MILLIMETRIC WAVE RADAR**

(57)   An antenna unit for sending out electromagnetic waves of a millimetric-wave band to outside and receiving the wave reflected from a target, and circuits for signal-processing the reflected wave are equipped as a vehicular millimetric-wave radar device. Antenna patterns are formed on a surface of a multilayer base plate formed of plural stacked layers of dielectric plates and an electroconductive layer interposed between each layer. Circuit wiring patterns and electronic components for signal processing of millimetric waves are disposed on the reverse side. Among all the above-mentioned electronic components, only a millimetric-wave signal oscillator, amplifier, and frequency converter are haused in a hermetically sealed section formed in a localized space on a face of the multilayer base plate. The other electronic components are arranged in a non-hermetically structured condition on a periphery of the hermetically sealed section. The above-mentioned oscillator, amplifier, and frequency converter are hermetically sealed in an inert gas atmosphere, whereas at least part of the other electronic components arranged in a non-hermetically structured condition is protected by resin coating. With this configuration, a compact, thin, and highly accurate millimetric-wave radar device is provided at a low cost.

## FIG. 1

EP 1 462 822 A1

## Description

Technical Field

The present invention relates to a vehicular millimetric-wave radar device, and more particularly to a mounting structure for a radiofrequency module integrated with an antenna unit.

Background Art

The vehicle-mounted types of radar devices that use millimetric waves or other radio waves to measure the distance and relative velocity with respect to a vehicle running in front have been developed in recent years. Millimetric waves, in particular, have the advantage that they reach to a great distance because of their small radio-beam attenuations even under rainy, foggy, or other unfavorable weather conditions.

As a mounting structure for a millimetric-wave radar device, the following is considered. The device has an antenna base with an antenna pattern formed on its surface and a base plate for a signal-processing circuit. The processing circuit is used for generating millimetric waves and processing sending/receiving signals, and comprises electronic components and electroconductive wiring pattern. The antenna base and the base plate are combined into an assembly and are housed in a case.

In prior arts, as a mounting technology of a integrated-type microwave circuit used for each wireless terminal unit of mobile-stations in a mobile wireless communication system, for example, Japanese Patent No. 2,840,493 describes as follows. It proposes that an antenna pattern is formed on one side of a multilayer base plate having plates and electroconductive layers stacked in multilayer structure, and various electronic components for sending and receiving signals are mounted on the other side of the multiplayer base plate.

The former mounting technology of the above-mentioned conventional technologies cannot sufficiently realize miniaturization of the device, since it has been necessary to manufacture the antenna base and the electronic-component mounting base plate independently and to stack them in multistage form with a space interposed between each stage.

The latter of the conventional technologies allows both sides of the multilayer base plate to be used effectively, and thus makes a compact device design realizable. These conventional technologies, however, does not describe structures in relation to moisture protection of radiofrequency circuits for millimetric waves, and the technologies on manufacture for preventing such problems has been unsolved.

Radiofrequency circuits of the millimetric wave type are particularly are prone to change in frequency characteristics according to humidity. Moisture protection is therefore important for these circuits.

An object of the present invention is to provide a vehicular millimetric-wave radar device capable of solving the above problems and realizing a compact and low-cost design while, at the same, ensuring high productivity and high reliability.

Disclosure of the Invention

To achieve the above object the present invention is basically constructed as follows:

A vehicular millimetric-wave radar device comprises an antenna unit for sending out electromagnetic waves of a millimetric-wave band to outside and receiving the waves reflected from a target; and a circuit for signal-processing the reflected waves. The radar device further includes a multilayer base plate formed of a plurality of stacked layers of dielectric plates and an electroconductive layer interposed between each layer. The multilayer base plate has, on one side, an antenna unit formed with a pattern, and on the other side, a circuit wiring pattern, and electronic components for signal processing of millimetric waves. Among the electronic components, a millimetric-wave signal oscillator, an amplifier, and a frequency converter are housed in a hermetically sealed section formed with a local space on the multilayer base plate. The other electronic components are arranged in a non-hermetically structured condition on a periphery of the hermetically sealed section.

Brief Description of the Drawings

Fig. 1 is a longitudinal sectional view of a millimetric-wave radar device according to a first embodiment of the present invention;
Fig. 2 is a partly cutaway plane view of the above millimetric-wave radar device;
Fig. 3 is a rear view of an integrated state of the radome and the multilayer base plate of the above embodiment;
Fig. 4 is a longitudinal sectional view of a millimetric-wave radar device according to a second embodiment of the present invention;
Fig. 5 is a view showing in section a connection state between the radome and multilayer base plate;
Fig. 6 is a partly enlarged sectional view of Fig. 5;
Fig. 7 is a sectional view showing an example of the above multilayer base plate;
Fig. 8 is an explanatory diagram showing a manufacturing process for the millimetric-wave radar device according to the above embodiment;
Fig. 9 is a diagram showing the principles of operation of the millimetric-wave radar device according to the present invention;
Fig. 10 is a circuit diagram of the millimetric-wave radar device shown in Fig. 9; and

Figs. 11 and 12 are diagrams showing a mounting scheme for components related to the millimetric-wave radar device used in the above embodiment.

Best Mode for Carrying Out the Invention

An embodiment of the present invention is described below on the basis of the accompanying drawings.

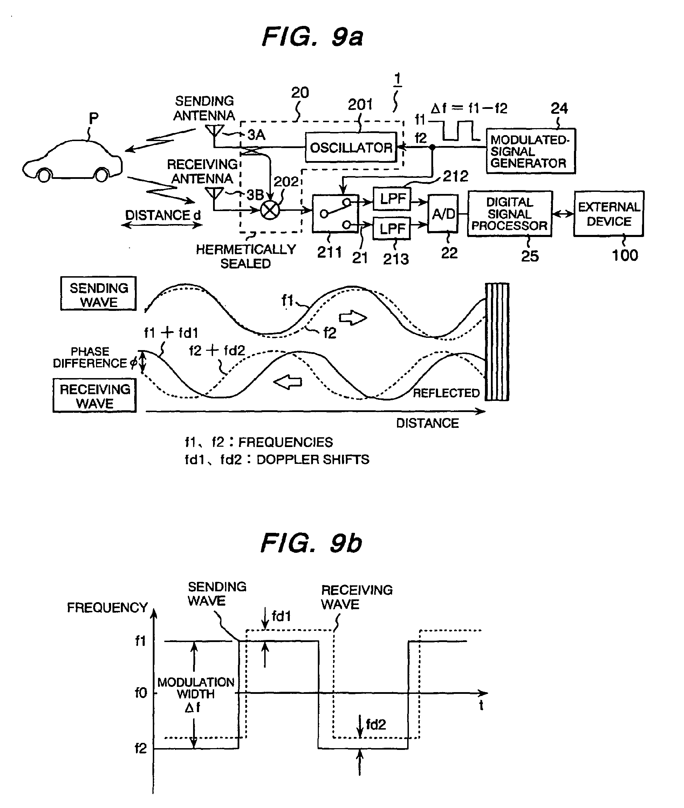

First, basic principles of a millimetric-wave radar device according to the present embodiment are described using Fig. 9.

A millimetric-wave radar device accordingg to the present embodiment employs a diplex Doppler radar, which is a typical radar.

A modulated-signal generator (modulator) 24 modulates two frequencies f1 and f2 generated with an oscillator 201, by means of rectangular-wave modulation in time-divided system (see Fig. 9(b)). The modulated signals are sent out from an sendingt antenna 3A. The signals are reflected from a target (e.g., a preceding vehicle) P, and the reflected signals are received with a receiving antenna 3B. The frequencies f1 and f2 are set to a range from, e.g., 76 to 77 GHz.

When a relative velocity V exists between the preceding vehicle P and the radar (own vehicle) 1, Doppler shifts fd1 and fd2 generate in the frequencies f1 and f2, respectively, and frequencies of the received signals become f1 + fd1 and f2 + fd2.

The received signals are converted into time-sharing signals of fd1 and fd2 with a mixer 202 constituted by a frequency converter. After the conversion, Doppler signals fd1 and fd2 are extracted via a switch circuit 211, which operates in synchronization with the modulated signals, and low-pass filters 212 and 213, then A/D converted, and input to a digital signal processor 25.

The phase difference of $\Delta\phi = \phi1 - \phi2$ between the frequencies f1 + fd1 and f2 + fd2, and the Doppler signals fd1 and fd2 can be easily calculated by discrete Fourier transform (FET).

The distance "d" between the target (preceding vehicle) and the own vehicle is represented by the following expression:

[Numerical expression 1]

$$d = C \cdot \phi/4\pi \cdot \Delta f$$

where C is a velocity of light (radio propagation rate) and $\Delta f$ is f1 - f2. The relative velocity "v" between the vehicles is represented by the following expression:

[Numerical expression 2]

$$v = C \cdot fd1/2f1 \text{ or } C \cdot fd2/2f2$$

The above FET and calculations with the numerical expressions 1 and 2 are each performed by digital signal processing.

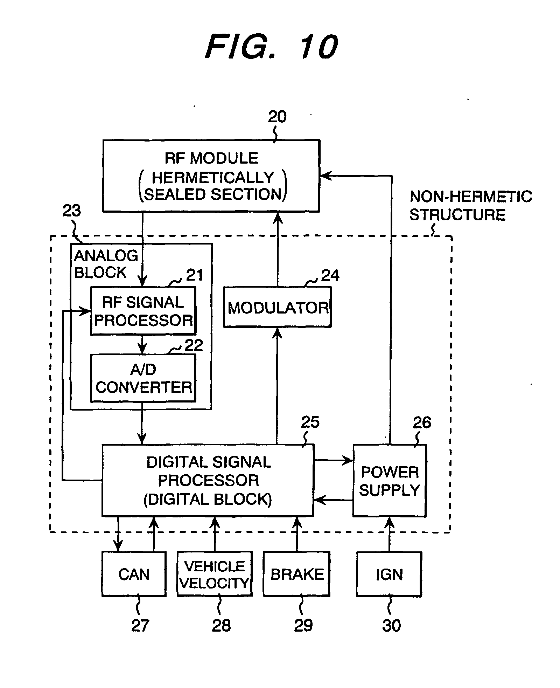

A block circuit diagram of the above basic principles is shown in Fig. 10.

An RF (Radio Frequency) module 20 is an integrated unit constituted by the oscillator 201 for forming millimetric-waves, the mixer (frequency converter) 202 shown in Fig. 9 and a sending/receiving amplifier (not shown in the figure). In the present embodiment, these elements are modularized using an IC (integrated circuit), and the module is housed as a hermetically sealed structure 45 on one face of a multilayer base plate 2 (described later).

An analog block 23 is comprised of an RF signal processor (analog section) 21 and an A/D converter 22. The RF signal processor (analog section) 21 is comprised of the switch circuit 211, low-pass filters 211 and 212 shown in Fig. 9. The Doppler signals fd1 and fd2 are converted analog-to-digital signals and then input to a digital signal processor 25.

The digital signal processor 25 controls the modulator 24. In addition, the digital signal processor 25 receives a vehicle velocity signal and brake signal from outer sensors, and then performs a vehicle safety decision (for example, alarm decision) based on these signals and the aforementioned signals such as the vehicle-to-vehicle distance signal and relative velocity signal etc.. After obtaining information based on the decision, the digital signal processor 25 sends the information to a vehicle control unit (external device) 100 by means of serial communications (CAN communications: Controlled Area Network). Thereby a vehicle-to-vehicle control signal, an alarm signal, and the like are generated, depending on particular conditions. When an ignition (IGN) key switch signal 30 is input, power is supplied from a power supply 26 of the millimetric-wave radar device 1.

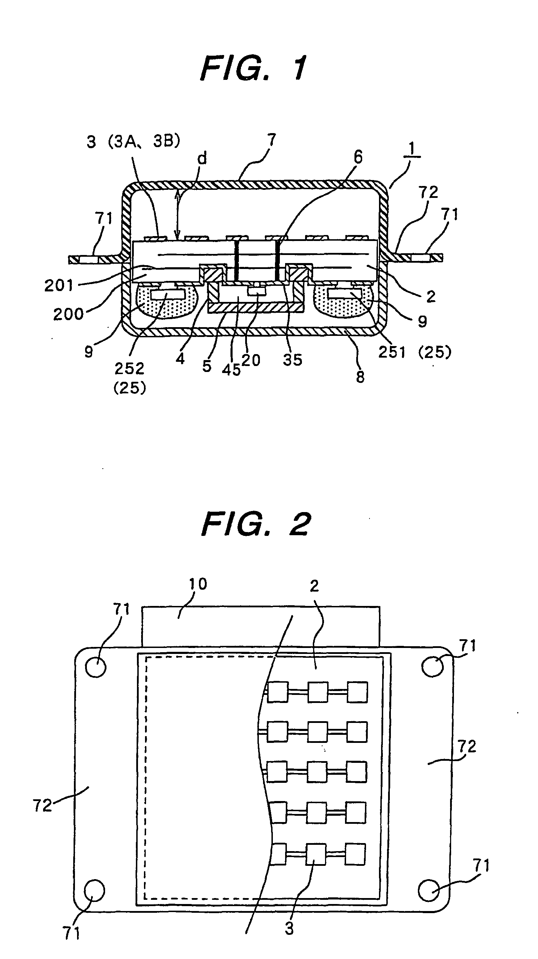

Fig. 1 is a longitudinal sectional view of a mounting structure for the millimetric-wave radar device of the present embodiment.

A multilayer base plate 2 is formed of a plurality of stacked layers of inorganic materials (dielectric plates) 200, and has an electroconductive layer 201 interposed between each layer.

On a surface of the multilayer base plate 2, an antenna unit 3 made of an organic material is formed by pattern printing. The antenna unit 3 includes, as shown in Fig. 2, a sending antenna 3A and receiving antenna 3B formed in a sectioned condition to constitute a patch antenna on the surface of the multilayer base plate 2.

On the other side of the multilayer base plate 2, wiring patterns (signal-processing circuit patterns) 35 are each formed of an electroconductive film, and electronic components for generating a millimetric waves and processing an input/output signal, are also provided.

In addition, in the multilayer base plate 2, via-holes 6 for transferring a signal are formed by being filled with an electroconductive material or by electromagnetic coupling. The antenna unit 3 is electrically connected to the signal-processing circuit wiring patterns 35 via the via-holes 6.

Among the above-mentioned electronic components, the RF module that includes the millimetric-wave signal oscillator 201, the mixer (frequency converter) 200 shown in Fig. 9(a) and an amplifier not shown in the figure, is housed within a hermetically sealed section 45 including a case 4 and a cover 5. Other electronic components (the electronic components used in the analog block 23 of Fig. 10, and the electronic components used in the digital signal processor 25) are arranged in a non-hermetically structured condition on a periphery of the hermetically sealed section 45. The hermetically sealed section 45 is, for example, formed in a local space in a central vicinity of the multilayer base plate 2 and internally charged with an inert gas such as a nitrogen gas. In general, the case 4 and the cover 5 are both formed of an inorganic material such as a ceramic material. Structurally, however, a metallic material can be used instead of it.

A microcomputer 251 and a high-speed signal-processing DSP (Digital Signal Processor) 252, both shown in Fig. 1, are for digitally processing an RF signal, and they constitute the digital signal processor 25 described above. These electronic components are arranged outside the case 4, and are each coated with an organic protection resin 9 to ensure protection from moisture and the like.

The multilayer base plate 2 equipped with the above-mentioned antenna unit and electronic components is covered with a plastic radome (radar dome) 7 that improves the passage of electromagnetic wave, and with a metallic case 8 that does not permit easy entry of noise or other external signals.

The radome 7 mechanically protects antenna patterns 3. Distance (design gap) "d" between the inner surface of the radome 7 and the face of the antenna unit side of the multilayer base plate 2 is set to an integer multiple of the wavelength of a millimetric wave. The reason is that setting the distance "d" to an integer multiple of one wavelength reduces millimetric wave (output signal) reflections and thus minimizes signal loss. For example, if the frequency of the millimetric waves is from 76 to 77 GHz, the length of one wave is from 3.90 to 3.95 mm. Therefore, the distance "d" is equal to $[(3.90 \text{ to } 3.95) \times N]$, where N is an integer multiple.

The RF module 20, the microcomputer 251, and the DSP 252, each provided on the surface of multilayer base plate 100, are protected from external radio noise waves by being covered with the above-mentioned metallic (electroconductive) case 8. The case 8, although formed basically of a metallic material, may be of a plastic material having a conductive material formed by plating or sputtering.

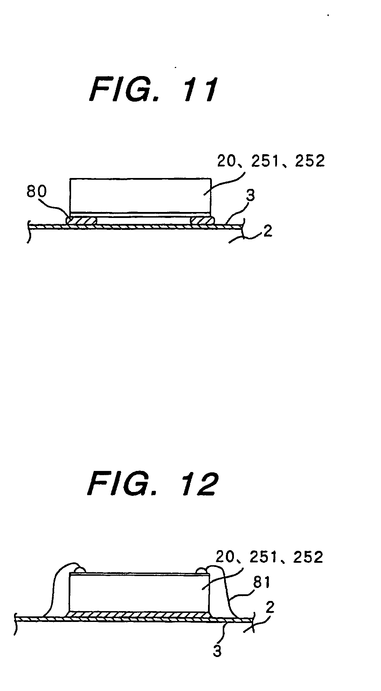

The RF module (IC chip) 20, microcomputer 251, and DSP 252 in the present embodiment are, as shown in Fig. 11, electrically connected by means of a face-down scheme, i.e., with an electrode side facing downward, to form bare chips via the wiring patterns 35 and solder 80 existing on the multilayer base plate 2. Alternatively, as shown in Fig. 12, the RF module 20, the microcomputer 251 and the DSP 252 may be electrically connected to the wiring patterns 35 on the multilayer base plate 2 via a wire-bonding element 81 by means of a face-up scheme, i.e., with an electrode side facing upward. Adoption of such a face-down or face-up mounting structure can assists to reduce the thickness of the device.

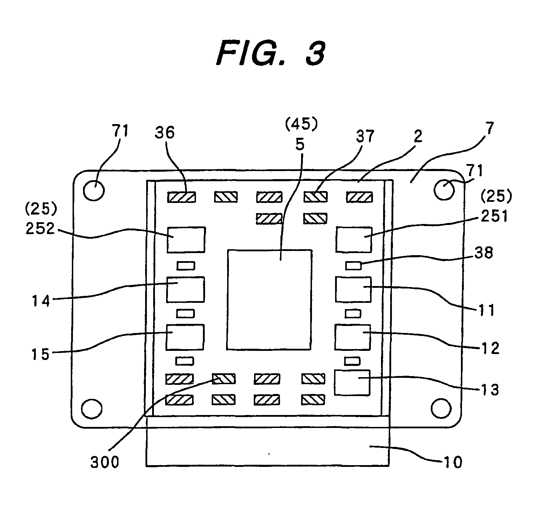

The layout of the electronic components of the millimetric-wave radar device in Fig. 1 is shown in Fig. 3.

On one side (reverse side) of the multilayer base plate 2, the hermetically sealed section 45 are located at the central position, on the other hand, the microcomputer 251, DSP 252, a custom IC 11, a power MOSIC 12, a power supply regulator 13, an operational amplifier 14, an A/D and D/A converter 15, chip resistors 36, chip capacitors 37 and chip diodes 38, etc are arranged around the hermetically sealed section.

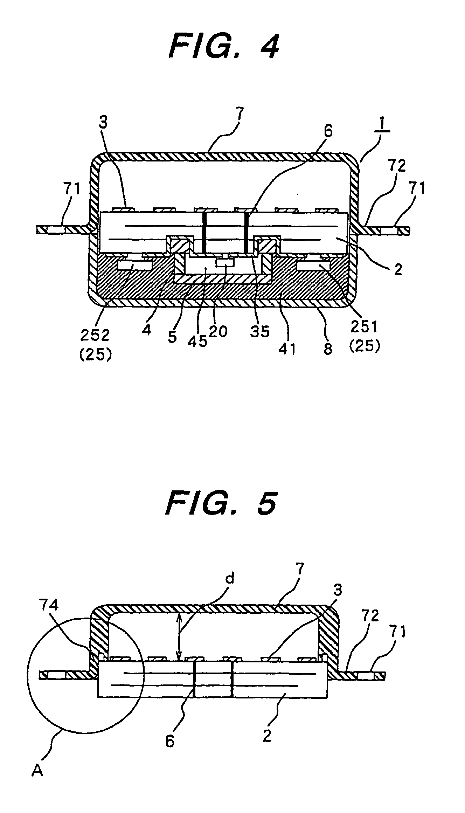

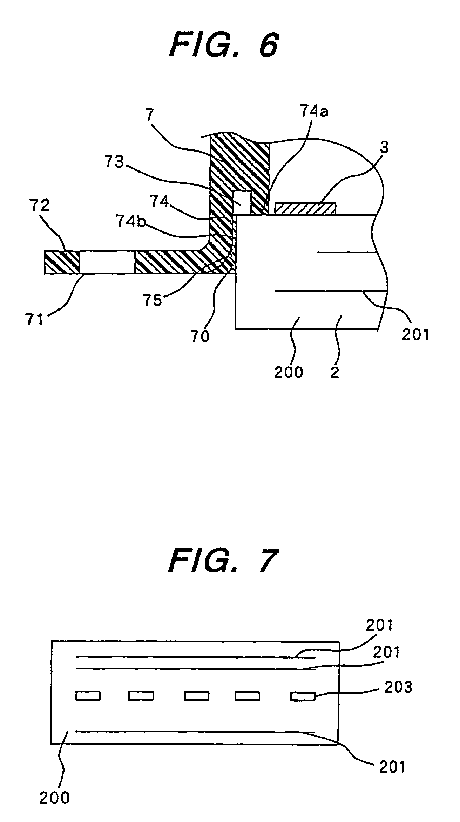

The radome 7 is bonded with the multilayer base plate 2 to form a structure integrated therewith. The best example of this bonded structure is described later using Figs. 5 and 6.

At both sides of the radome 7; an overhang portion 72 protruding outwardly with respect to the case 8 is formed, and a plurality of installation holes 72 for installing the millimetric-wave radar device 1 at a required section are provided in both overhang portions 72. By coupling the radome 7 directly to the multilayer base plate 2, it becomes easy to get the dimension "d" between the surface of the multilayer base plate 2 and an inner surface of the radome 7 (it is easy to keep a parallel clearance between them by means of the dimension "d") during the manufacturing process for the device. Also, since the integrated unit formed of the radome 7 and the multilayer base plate 2 can be installed so as to face in a required direction without interposing other members. It is possible to eliminate factors likely to cause dimensional errors in other members, and thus to install the antenna unit 3 accurately. These structure schemes can therefore improve sending/receiving sensitivity. After the radome 7 and the multilayer base plate 2 have been bonded, the case 8 is bonded with the radome 7 and/or the multilayer base plate 2.

Here, the best example of a bonded structure between the multilayer base plate 2 and the radome 7 is described using Figs. 5 and 6.

At an inner edge of an opening of the radome 7 is formed an engagement portion 74 that engages with a peripheral edge of the multilayer base plate 2. The engagement portion 74 is formed with a first face 74a oriented towards the face of the antenna unit side on the multilayer base plate 2 and a second face 74b oriented towards the side of the multilayer base plate 2. An outwardly spread curve 75 is formed at a section where the first face 74a and the overhang portion 72. The spread curve is provided for allowing easy supply of an adhesive 70 into the section to be bonded between the radome 7 and the multilayer base plate 2. In addition, a groove 73 is formed in the face 74a.

By putting the above-mentioned face 74a to the surface of the multilayer base plate 2, a required design gap "d" can be accurately secured between the multilayer base plate 2 and the radome 7. After the multilayer base plate 2 and the radome 7 have been put to together, the adhesive 70 is charged into the section to be bonded between the base plate 2 and the radome 7. At this time, even if the section to be bonded overflows with the adhesive 70, the excess thereof is received into the groove (adhesive gutter) 73. Accordingly, it makes possible to prevent the adhesive 70 from entering the millimetric-wave device, and thus to improve product quality.

On one face of the radome 7, a connector 10 with external connection terminals is formed integrally with the radome 7.

As shown in Fig. 3, a temperature sensor 300 is disposed on the multilayer base plate 2. Since the oscillator 20 for generating the millimetric waves could change in characteristics with temperature, the temperature sensor 300 monitors a temperature state of the multilayer base plate 2. Thus, an oscillation frequency of the oscillator IC is monitored, the oscillation frequency is maintained by temperature control, and a warning is issued if a shift in the oscillation frequency oversteps a predetermined range.

A longitudinal sectional view of a multilayer base plate 2 according to another embodiment is shown in Fig. 7.

The multilayer base plate 2 in Fig, 7 has a plurality of heaters 203 interposed between layers, and is adapted so that the uniformity of temperature can be obtained. The heaters 203 are each set so as to be controlled to a required temperature on the basis of a value detected by the temperature sensor 300. To stabilize the characteristics of the millimetric-wave oscillator, temperature control and temperature uniformity of the device itself of Fig. 1 are important. A millimetric-wave frequency of 76.5 GHz, in particular, is required by the Radio Law to stay between 76 and 77 GHz within a particular operating temperature range.

In order to realize the above, the heaters 203 are formed inside the multilayer base plate 2 and function together with the foregoing temperature sensor 300 to control temperature. The heaters 300 use a power supply voltage of 30-40 V to miniaturize a heater control IC.

In the embodiment of Fig. 1, the microcomputer 251, the DSP 252 and other electronic components are each coated with organic protection resin 9 to ensure protection from moisture. Alternatively to such coating, however, even if, as shown in Fig. 4, an organic protection resin 41 is charged into the space (except for the hermetically sealed section 45) between the case 8 and the multilayer base plate 2, there is no problem in terms of characteristics.

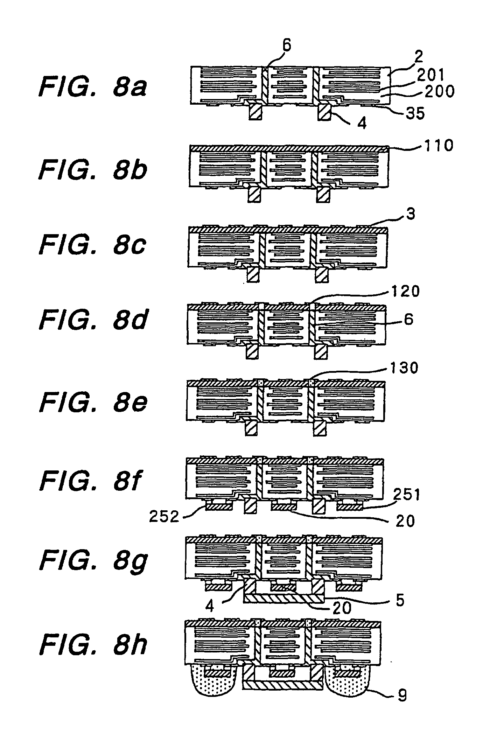

Next, a manufacturing process for a major section (module) of the millimetric-wave radar device according to the present embodiment is described below using Fig. 8.

A multilayer base plate 2 is formed by stacking in layer fashion a plurality of green sheets, each of which comprises a dielectric plate 200, and then baking these elements with an electroconductive layer 20 being interposed between layers. The electroconductive layer 201 is constituted by a power supply layer, a ground layer for each power supply, and other layers.

As shown in Fig. 8(a), on the multilayer base plate 2, via-holes 6 are formed and on the reverse side of the multilayer base plate 2, wiring patterns 35 and cases 4 are formed.

Next, as shown in (b) and (c), a resin film 110 is formed on the multilayer base plate 2, then a metal film is formed on the resin film 110, and patterning is provided to form antenna patterns 3. Next, as shown in Figs 8(d) and 8(e), a hole 120 is made in part of an electroconductive section of the antenna patterns 3 and then an electroconductive material 130 is charged into the hole 20 by sputtering or the like so that the antenna patterns 3 are connected to a via-hole 6. After this, as shown in (f) to (h), an RF module chip 20, a microcomputer 251, a DSP 252, and other electronic components are bonded to form an electric signal circuit. In addition, a cover 5 is bonded with the cases 4 to form a hermetically sealed structure, and the microcomputer 251, the DSP, and other bare chips are each coated with organic protection resin 40.

During the above manufacturing process, antenna characteristics against millimetric waves are checked in the step shown in Fig. 8(g), i.e., in a step performed after the RF module 20 has been hermetically sealed (before other electronic components are mounted). In addition, total input/output characteristics are checked in a step performed after all electronic components have been mounted on the multilayer base plate 2, as shown in Fig. 8(h).

According to the present embodiment, the following effects are obtained:

(1) Since the antenna patterns 3 and the electronic components for processing signals are integrally provided on the multilayer base plate 3, it is possible to enhance component-mounting density and make the device more compact.

(2) Even if the oscillator, amplifier, and frequency converter for processing an antenna signals are constituted by a bare IC, by sealing these electronic components hermetically for complete moisture protection, the frequency characteristics of millimetric waves can be prevented from changing. The present embodiment provides a hermetically sealed structure to the millimetric-wave oscillator and the frequency converter required to proof against severe moisture conditions, whereas provides simplified resin coating to the microcomputer, DSP and other bare-chip components loosened in terms of moisture-proofing conditions, compared with the foregoing components. Accordingly, the hermetically sealed structure needed comparatively high- cost can be applied only to the minimum necessary number of components, and a locally narrow space is sufficient for the installation space of the components required the hermetic seal. And the other electronic components not required a severe hermetically sealed condition are arranged on the periphery of the above severe hermetically sealed components. It is therefore possible to realize the enhancement of component-mounting density and reduction in costs.

(3) By hermetically sealing only the millimetric-wave oscillator, amplifier, and frequency converter in a localized space and independently of other electronic components, it is possible to test and check antenna characteristics prior to measuring and checking the input/output characteristics of the entire device. Accordingly, if any defective components are detected in this phase, an unnecessary waste of components can be avoided since it is possible to eliminate the defective components before starting total component assembly.

(4) Since the device is constructed so that the design gap between the antenna unit and the radome can be easily controlled in terms of manufacturing dimensions, and by preventing the reflection of millimetric-wave output signals from the radome surface, it is possible to enhance radar accuracy.

(5) Radar accuracy can be further enhanced by improving the mounting accuracy of the millimetric-wave radar device.

Industrial Applicability

According to the present invention, circuits for generating millimetric-wave radar antenna signals and undertaking input/output processing, and circuits for receiving and processing input signals can be integrated and a compact, thin. Furthermore highly accurate millimetric-wave radars can be provided at a low cost.

**Claims**

1. A vehicular millimetric-wave radar device comprising:

   an antenna unit for sending out electromagnetic waves of a millimetric-wave band to outside and receiving the wave reflected from a target; and

   a circuit for signal-processing the reflected waves;

   wherein

   said radar device further includes a multilayer base plate formed of a plurality of stacked layers of dielectric plates and an electroconductive layer interposed between each layer;

   said multilayer base plate has, on one side, said antenna unit formed with a pattern, and on the other side, a circuit wiring pattern and electronic components for signal processing of millimetric waves; and

   among said electronic components, a millimetric-wave signal oscillator, an amplifier and a frequency converter are housed in a hermetically sealed section formed with a local space on said multilayer base plate, and the other electronic components are arranged in a non-hermetically structured condition on the periphery of said hermetically sealed section.

2. The vehicular millimetric-wave radar device according to claim 1, wherein said millimetric-wave signal oscillator, said amplifier, and said frequency converter are hermetically sealed in an inert gas atmosphere, whereas at least part of said other electronic components arranged in a non-hermetically structured condition is protected by resin coating.

3. The vehicular millimetric-wave radar device according to claim 1 or 2, wherein said multilayer base plate on which said antenna patterns, said hermetically sealed section and said electronic components are mounted is covered with a plastic radome and an electroconductive case.

4. The vehicular millimetric-wave radar device according to any one of claims 1 to 3, wherein said millimetric-wave signal oscillator, said amplifier, and said frequency converter are housed in IC form within said hermetically sealed section.

5. The vehicular millimetric-wave radar device according to any one of claims 1 to 4, further comprising a plastic radome for covering the face of the antenna unit side on said multilayer base plate, and an electroconductive case for covering the face of the electronic components side on said multiplayer base plate;

   wherein

   said radome is bonded with said multilayer base plate to form a structure integrated therewith;

   overhang portions protruding outwardly with respect to said case is formed on said radome; and

   holes for installing said millimetric-wave radar device are provided at said overhang portions.

6. The vehicular millimetric-wave radar device according to any one of claims 1 to 5, further comprising a plastic radome for covering the face of the antenna unit side on said multilayer base plate; wherein

overhang portions protruding outwardly is formed at both sides of said radome;

an engagement portion engaging with the peripheral edge of said multilayer base plate is formed at the inner edge of an opening in said radome;

said engagement portion is formed of a first face put to the face of the antenna unit side of said multilayer base plate and a second face adjoining the side of said multilayer base plate,;

an outwardly spread curve is formed at a section where said first face and said overhang portion intersect;

a groove is formed at the first face; and

said multilayer base plate is in engagement with the inner edge of the opening of said radome via an adhesive.

7. The vehicular millimetric-wave radar device according to claim 3, 5 or 6, wherein said radome is molded integrally with a connector having input/output terminals for connecting external terminals.

8. The vehicular millimetric-wave radar device according to any one of claims 1 to 7, further comprising a temperature sensor on the surface or inside of said multilayer base plate.

9. The vehicular millimetric-wave radar device according to any one of claims 1 to 8, further comprising a heater on said multilayer base plate, said heater being controlled at a voltage from 30 to 50 V.

10. The vehicular millimetric-wave radar device according to any one of claims 1 to 9, wherein the distance between the inner surface of said radome and the face of the antenna side of said multilayer base plate is equal to an integer multiple of a wavelength of the millimetric wave.

# FIG. 1

3 (3A、3B)   7   6   1   72   71
d
71
2
201
200
9
252
(25)
4   5   45   20   35   8   251 (25)
9

# FIG. 2

10   2
71   71
72   72
72
71   3   71

# FIG. 3

## FIG. 4

## FIG. 5

## FIG. 6

## FIG. 7

**FIG. 8a**

**FIG. 8b**

**FIG. 8c**

**FIG. 8d**

**FIG. 8e**

**FIG. 8f**

**FIG. 8g**

**FIG. 8h**

## FIG. 9a

f1, f2 : FREQUENCIES
fd1, fd2 : DOPPLER SHIFTS

## FIG. 9b

## FIG. 10

# FIG. 11

20、251、252
80
3
2

# FIG. 12

20、251、252
81
2
3

| INTERNATIONAL SEARCH REPORT | International application No. |
|---|---|
| | PCT/JP01/09821 |

**A. CLASSIFICATION OF SUBJECT MATTER**
Int.Cl⁷   G01S13/93, G01S7/28

According to International Patent Classification (IPC) or to both national classification and IPC

**B. FIELDS SEARCHED**

Minimum documentation searched (classification system followed by classification symbols)
Int.Cl⁷   G01S7/00-17/88

Documentation searched other than minimum documentation to the extent that such documents are included in the fields searched
Jitsuyo Shinan Koho          1922-1996      Toroku Jitsuyo Shinan Koho  1994-2001
Kokai Jitsuyo Shinan Koho  1971-2001      Jitsuyo Shinan Toroku Koho  1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | EP 978729 A2 (Hitachi, Ltd.),<br>09 February, 2000 (09.02.00),<br>Full text; all drawings<br>Full text; all drawings<br>& JP 12-59140 A    & JP 12-209026 A | 1<br>2-5 |
| X<br>Y | JP 8-250913 A (Honda Motor Co., Ltd.),<br>27 September, 1996 (27.09.96),<br>Full text; all drawings    (Family: none)<br>Full text; all drawings    (Family: none) | 1<br>2-5 |
| Y | EP 800093 A1 (Honda Giken Kogyo Kabushiki Kaisha),<br>08 October, 1997 (08.10.97),<br>Full text; all drawings<br>& JP 9-275160 A    & JP 10-2953 A<br>& US 6130640 A1 | 2 |
| Y | JP 54-11696 A (Tokyo Shibaura Denki K.K.),<br>27 January, 1979 (27.01.79),<br>Full text; all drawings    (Family: none) | 2 |

☒ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>07 December, 2001 (07.12.01) | Date of mailing of the international search report<br>18 December, 2001 (18.12.01) |
|---|---|
| Name and mailing address of the ISA/<br>Japanese Patent Office | Authorized officer |
| Facsimile No. | Telephone No. |

Form PCT/ISA/210 (second sheet) (July 1992)

**EP 1 462 822 A1**

**INTERNATIONAL SEARCH REPORT**

International application No.

PCT/JP01/09821

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | DE 19859002 A1 (Robert Bosch GmbH),<br>29 June, 2000 (29.06.00),<br>Full text; all drawings<br>& JP 12-196346 A    & FR 2789522 A | 3 |
| Y | EP 638818 A1 (Siemens Aktiengesellschaft),<br>15 February, 1995 (15.02.95),<br>Fig. 6<br>& JP 7-55917 A    & DE 59309609 C<br>& US 5497163 A1    & AT 180575 E | 5 |

Form PCT/ISA/210 (continuation of second sheet) (July 1992)

17